# EUROPÄISCHE PATENTSCHRIFT

(11) **EP 0 933 819 B1**
(45) Veröffentlichungstag und Bekanntmachung des Hinweises auf die Patenterteilung: **05.04.2006**
(21) Anmeldenummer: 99100512.5
(22) Anmeldetag: 12.01.1999
(51) Int. Cl.: H01L 29/06, H01L 21/78, H01L 21/18

(54) **Verfahren zur Herstellung eines beidseitig sperrenden Leistungshalbleiters**
Method of fabricating a bidirectionally blocking power semiconductor
Procédé de fabrication d'un semiconducteur de puissance bloquant dans les deux sens

(30) Priorität: 03.02.1998 DE 19804191
(43) Veröffentlichungstag der Anmeldung: 04.08.1999
(73) Patentinhaber: Infineon Technologies AG, 81669 München (DE)
(72) Erfinder: Schulze, Hans-Joachim Dr., 85521 Ottobrunn (DE)
(74) Vertreter: Patentanwälte Westphal, Mussgnug & Partner

(56) Entgegenhaltungen:
- EP-A- 0 341 075
- EP-A- 0 387 721
- WO-A-96/03774
- US-A- 5 072 312
- PATENT ABSTRACTS OF JAPAN vol. 011, no. 007 (E-469), 9. Januar 1987 & JP 61 182259 A (TOSHIBA CORP), 14. August 1986
- PATENT ABSTRACTS OF JAPAN vol. 011, no. 007 (E-469), 9. Januar 1987 & JP 61 182260 A (TOSHIBA CORP), 14. August 1986

## Beschreibung

Die Erfindung betrifft ein Verfahren zum Herstellen eines beidseitig sperrenden Leistungsbauelements, wie z. B. ein Thyristor oder ein Bipolar-Transistor mit isoliertem Gate (IGBT = insulated gate bipolar transistor), auf einem Wafer, bei dem Halbleiterstrukturen auf einer ersten Seite der Oberfläche einer Scheibe erzeugt werden, wobei die Scheibe von einem ersten Leitungstyp ist und die Halbleiterstrukturen mindestens eine Wanne von einem zweiten Leitungstyp an der Oberfläche der Scheibe umfassen.

Aus EP-A-0341 075 entspricht dem Oberbegriff des Anspruches 1 ist ein Verfahren zum Herstellen eines beidseitig sperrenden Leistungsbauelements auf einem Substrat bekannt, bei dem auf der Oberfläche des Substrats eine epitaktische Schicht und auf der vom Substrat abgekehrten Oberfläche der epitaktischen Schicht Halbleiterstrukturen erzeugt werden, wobei die epitaktische Schicht von einem ersten Leitungstyp ist und die Halbleiterstrukturen mindestens eine Wanne von einem zweiten Leitungstyp an der Oberfläche der epitaktischen Schicht umfassen, wobei in der epitaktischen Schicht im Bereich jeder Wanne je ein Graben erzeugt wird, wodurch auf der Oberfläche der epitaktischen Schicht je ein Anschlussbereich des zweiten Leistungstyps auf der Oberfläche der epitaktischen Schicht erzeugt wird, der einen Randabschluss für eine Rückwärtssperrfähigkeit des Bauelements enthält, und wobei auf der frei liegenden Oberfläche des Grabens eine erste Schicht des zweiten Leitungstyps erzeugt wird, so dass ein elektrischer Kontakt zwischen dem Substrat und dem Anschlussbereich hergestellt wird.

Auch aus EP-A- 387 721 und WO-96/03774 geht jeweils ein Verfahren zum Herstellen eines Leistungsbauelements auf einem Substrat hervor, bei dem auf der Oberfläche des Substrats eine epitaktische Schicht und auf der vom Substrat abgekehrten Oberfläche der epitaktischen Schicht Halbleiterstrukturen erzeugt werden.

Bei großflächigen Leistungshalbleitern - wie Thyristoren und abschaltbaren Thyristoren (GTOs) - wird die Rückwärtssperrfähigkeit i. a. durch mechanische Erzeugung wie Schrägschleifen (Läppen) oder Sandstrahlbearbeitung (Sanden) von positiven oder negativen Winkeln realisiert. Durch das Abschrägen des Randes kann das Oberflächenfeld deutlich abgesenkt werden und damit sichergestellt werden, dass ein Durchbruch innerhalb des Halbleiters und nicht an dessen Oberfläche erfolgt.

Ein Abschrägen des Randes ist aber bei kleinen Bauelementen - wie z. B. dem IGBT - nicht möglich, da dies sehr kostenaufwendig wäre und außerdem den Übergang auf einen runden Chip erfordern würde. Außerdem werden z. B. beim IGBT deutlich geringere Eindringtiefen der pn-Übergänge verwendet. Dies schließt die Verwendung mechanisch erzeugter Randabschlüsse weitgehend aus. Im Stand der Technik kommen daher hierfür planare Randabschlüsse wie z. B. Feldringstrukturen zur Anwendung. Der Nachteil bei Feldringstrukturen ist jedoch, dass man bei einem beidseitig sperrenden Bauelement für beide Polungsrichtungen jeweils auf der Vorder- und Rückseite der Halbleiterscheibe einen Randabschluss benötigt. Das ist nur mit einer aufwendigen, beidseitigen Fototechnik möglich.

Eine Alternative bietet die Trenndiffusion, d. h. das Eindiffundieren einer Trennschicht in das Substrat. Mit der Trennschicht kann eine leitende Verbindung zwischen Vorder- und Rückseite der Halbleiterscheibe im Randbereich erzeugt werden.

Die Trenndiffusion wird heute nur in Form einer Al-Diffusion realisiert, da Al schnell diffundiert, wesentlich schneller als z. B. Bor. Nachteilig ist hierbei jedoch, dass auch bei Einsatz einer Al-Diffusion selbst bei einer relativ geringen Scheibendicke von 300 µm und bei einer relativ hohen Diffusionstemperatur von ca. 1240°C eine Eintreibzeit von mindestens 50 Stunden erforderlich ist, was mit einer sehr hohen Materialbelastung verbunden ist. Vor allem aber ist die Anwendung von Al-Diffusionen in IC-Linien, in denen die Herstellung von IGBTs erfolgt, i. a. nicht zulässig, da Al nicht durch SiO₂ maskierbar ist und somit Cross-Kontaminationen befürchtet werden, die u. a. eine Degradation des Gate-Oxids zur Folge haben können.

Aufgabe der vorliegenden Erfindung ist es daher, ein Verfahren zur Herstellung eines beidseitig sperrenden Leistungsbauelements anzugeben, das einfach umzusetzen und kostengünstig ist und die obigen Nachteile überwindet.

Diese Aufgabe wird erfindungsgemäß gelöst durch ein Verfahren zum Herstellen eines Leistungsbauelements mit den Merkmalen nach Anspruch 1. Die abhängigen Ansprüche beziehen sich auf bevorzugte Ausführungsformen der Erfindung.

Die erfindungsgemäße Lösung beruht darauf, dass alle Randabschlüsse des Leistungsbauelements auf die Vorderseite des Bauelements gelegt werden. Damit können alle Bearbeitungsschritte bei der Herstellung des Bauelements auf die Vorderseite bezogen werden. Dies ermöglicht eine Vereinfachung des Herstellungsverfahrens und damit eine kostengünstigere Herstellung als beim Stand der Technik. Insbesondere kann durch eine Grabenätzung im Randbereich der Scheiben eine Trenndiffusion z. B. mittels einer Bordiffusion bei relativ geringem Aufwand an Zeit und geringer Temperaturbelastung realisiert werden. Zur mechanischen Unterstützung der Scheibe wird die zu ätzende Scheibe dazu auf einem (Träger-) Substrat befestigt.

Das erfindungsgemäße Verfahren zum Herstellen mehrerer beidseitig sperrender, vertikaler Leistungsbauelemente auf einem Wafer, das umfasst: Erzeugen von Halbleiterstrukturen auf einer ersten Seite der Oberfläche einer Scheibe, wobei die Scheibe von einem ersten Leitungstyp ist und die Halbleiterstrukturen mindestens eine Wanne von einem zweiten Leitungstyp an der Oberfläche der Scheibe umfassen, ist gekennzeichnet durch die Schritte:
a) Verbinden der Scheibe auf einer von der ersten Seite der Oberfläche abgekehrten zweiten Seite der Scheibe mit einem Substrat von einem zweiten Leitungstyp zu einem Wafer;
b) Erzeugen von jeweils einem Graben in der Scheibe an dem Rand eines Leistungsbauelements auf dem Wafer;
c) Erzeugen eines Anschlussbereichs von dem zweiten Leitungstyp auf der ersten Seite der Scheibe und einer ersten Schicht von dem zweiten Leitungstyp auf der frei liegenden Oberfläche des Grabens, so dass ein elektrischer Kontakt zwischen dem Substrat und dem Anschlussbereich hergestellt wird.

Vorzugsweise wird vor dem Verbinden mit dem Substrat eine zweite Schicht von dem zweiten Leitungstyp auf der zweiten Seite der Oberfläche der Scheibe erzeugt und anschließend die Scheibe mit dem Substrat über die zweite Schicht verbunden. Dadurch wird erreicht, dass die Raumladungszone in der Scheibe gebildet wird und nicht direkt über der Grenzfläche zwischen der Scheibe und dem Substrat. Bei der Bildung der Raumladungszone um die Grenzfläche herum wäre dagegen eine höhere Oberflächengüte sowohl bei der Scheibe als auch beim Substrat erforderlich, was die Kosten erhöhen würde.

In einer bevorzugten Ausführungsform des Verfahrens wird die Scheibe mit dem Substrat mit der Wafer-Bonding-Methode zu einem Wafer verbunden.

In einer bevorzugten Ausführungsform des Verfahrens wird die erste und/oder zweite Schicht und/oder ein Anschlussbereich durch Diffusion von Bor, insbesondere durch Diffusion von Diboran hergestellt.

In einer weiteren bevorzugten Ausführungsform des Verfahrens wird die erste und/oder zweite Schicht und/oder ein Anschlussbereich durch Implantation von Bor hergestellt. Dabei liegt die Implantationsdosis vorzugsweise zwischen 10¹⁴/cm² und 10¹⁶/cm². Zum Eindiffundieren der Bor-Atome ist ein nachfolgender Hochtemperaturschritt erforderlich. Dieser erfolgt vorzugsweise bei einer Temperatur von ca. 1100 bis 1300°C über eine Zeitdauer von ca. 10 Stunden.

Vorzugsweise erhält die erste Schicht eine Dicke von mindestens etwa 3 µm.

Die Randabschlüsse, die sich an den mit der zweiten Seite der Halbleiterscheibe elektrisch verbundenen Anschlussbereich und die Basiszone des zweiten Leitungstyps auf der ersten Seite der Halbleiterscheibe anschließen, werden vorzugsweise als Feldringstrukturen oder allgemein als Struktur mit lateral abnehmender Dotierung erzeugt.

Werden die einzelnen Bauelemente unabhängig betrieben, so wird vorzugsweise der Halbleiter entlang des Grabens in einzelne Chips getrennt, wobei das Trennen durch Sägen durch die Grabenmitte erfolgen kann.

Der Vorteil der Erfindung liegt darin, dass bei dieser Anordnung mit einseitigem Randabschluss nicht wie bei Realisierung eines zusätzlichen anodenseitigen (kollektorseitigen) Randabschlusses eine beidseitige Fototechnik mit möglichst genauer Passivierung und Verbindungstechnik auf der Anodenseite (Kollektorseite) erforderlich ist, sondern alle Bearbeitungsschritte bei der Herstellung des Leistungsbauelements auf einer Seite desselben erfolgen können. Ferner ist die Trenndiffusion mittels Bordotierung bei relativ geringen Diffusionszeiten möglich und daher mit der IC-Herstellung verträglich.

Das Leistungsbauelement, das mit dem erfindungsgemäßen Verfahren hergestellt wurde, weist neben einer Vorwärtssperrfähigkeit auch eine Rückwärtssperrfähigkeit auf, und es wird bei ihm sowohl der Randabschluss für den in Vorwärtsrichtung als auch der Randabschluss für den in Rückwärtsrichtung sperrenden pn-Übergang auf der Kathodenseite (Emitterseite) des Bauelements realisiert.

Weitere Merkmale und Vorteile der Erfindung ergeben sich aus der Beschreibung eines zeichnerisch dargestellten, mit einer Ausführungsform des erfindungsgemäßen Verfahrens hergestellten Leistungsbauelements.

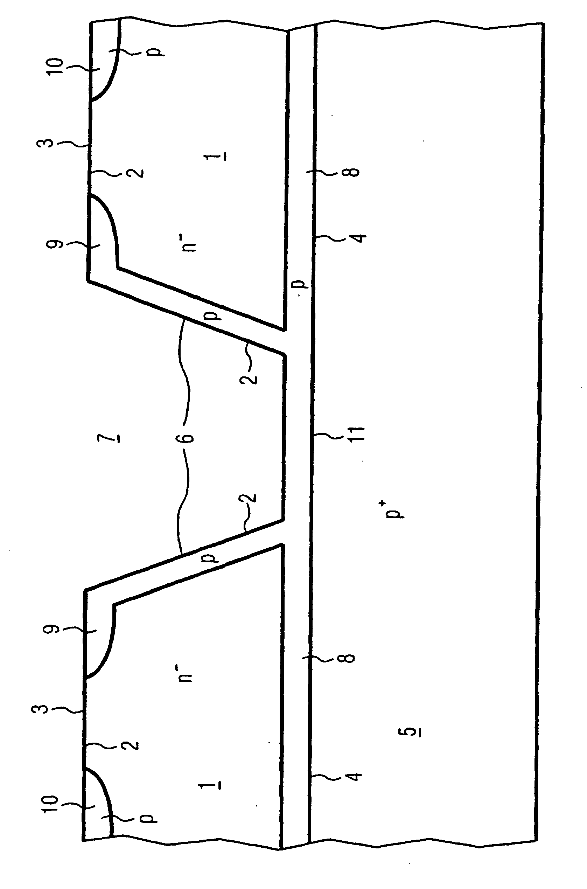

Fig. 1 zeigt einen Ausschnitt eines mit dem erfindungsgemäßen Verfahren hergestellten Leistungsbauelement im Querschnitt.

Das Leistungsbauelement nach Fig. 1 umfasst eine Scheibe 1 von einem ersten Leitungstyp. Die Scheibe 1 ist in dem dargestellten Beispiel schwach n-dotiert und ist daher in Fig. 1 mit n⁻ bezeichnet. Die Dicke der Scheibe kann in etwa 300 µm oder weniger betragen. Allgemein wird die Dicke und die Grunddotierung der niedrig dotierten Siliziumscheiben 1 je nach angestrebter Sperrspannung des Leistungsbauelements gewählt.

Auf der ersten Seite 3 ihrer Oberfläche 2 wird die Scheibe 1 mit Halbleiterstrukturen versehen, die mindestens eine Wanne 10 vom zweiten Leitungstyp umfassen. Der obere Abschnitt der Fig. 1 wird in Anlehnung an diese Elektroden im folgenden als emitterseitig oder kathodenseitig bezeichnet, und der untere Abschnitt der Fig. 1 wird entsprechend als kollektorseitig oder anodenseitig bezeichnet. Das Verfahren zur Herstellung von Halbleiterstrukturen mit wenigstens einer Wanne 10 ist allgemein bekannt und wird hier nicht weiter erläutert.

In einem Schritt a) des erfindungsgemäßen Verfahrens wird die Scheibe 1 mit einem Substrat 5 verbunden, das von einem zweiten Leitungstyp ist und das in Fig. 1 unterhalb der Scheibe 1 dargestellt ist. Das Substrat kann z. B. eine Dicke von etwa 400 µm aufweisen. Die Scheibe 1 und das Substrat 5 haben nach der Verbindung eine gemeinsame Grenzfläche 11.

Die Verbindung der Scheibe 1 mit dem Substrat 5 kann insbesondere mit der "Wafer-Bonding"-Technik erfolgen. Der Prozess des Wäfer-Bonding ist auf dem Gebiet der Halbleiterherstellung allgemein bekannt und wird hier nicht weiter erläutert.

Das Leistungsbauelement nach Fig. 1 weist eine zusätzliche, zweite Schicht 8 auf. Bei der bevorzugten Ausführungsform des erfindungsgemäßen Verfahrens wird die Scheibe 1 vor dem Verbinden mit dem Substrat 5 auf der zweiten Seite 4 ihrer Oberfläche 2 mit der zweiten Schicht 8 versehen, bevor sie in Schritt a) des Verfahrens mit dem Substrat 5 verbunden wird. Die in der Scheibe 1 erzeugte zweite Schicht 8 ist von einem zweiten Leitungstyp, der dem ersten Leitungstyp der Scheibe 1 entgegengesetzt ist. In dem dargestellten Beispiel ist der Leitungstyp der Scheibe 1 mit n⁻ und der Leitungstyp der zweiten Schicht 8 mit p bezeichnet.

Durch die Erzeugung der zweiten Schicht 8 in der Scheibe 1 wird erreicht, dass die (nicht dargestellte) Raumladungszone innerhalb der Scheibe 1 gebildet wird (genauer gesagt am Übergang zwischen dem n⁻-Bereich der Scheibe 1 und dem p-Bereich der zweiten Schicht) und nicht direkt über der Grenzfläche 11 zwischen der n⁻-dotierten Scheibe 1 und dem p⁺⁻dotierten Substrat 5. Ohne die zusätzliche Schicht 8 in der Scheibe 1 wäre bei der Bildung der Raumladungszone um die Grenzfläche 11 herum dagegen eine hohe Oberflächengüte sowohl bei der Scheibe 1 als auch beim Substrat 5 und zusätzlich ein extrem defektfreies Wafer-bonding erforderlich, was die Kosten des Materials bzw. des Herstellungsverfahrens erhöhen würde.

Das Anbringen der Scheibe 1 auf dem Substrat 5 bewirkt eine höhere mechanische Stabilität des Gesamtaufbaus und ermöglicht die Ätzung eines tiefen Grabens 7 in die niedrig dotierte Siliziumscheibe 1, ohne dass diese zerbricht. Das Substrat 5 mit seiner Dicke von etwa 400 µm wirkt als stabilisierender Träger. Insbesondere im Fall geringer Dicken der niedrig dotierten Siliziumscheiben 1 erleichtert der Träger 5 außerdem die Bearbeitung der Siliziumscheiben 1 im Prozessablauf und vor allem das Scheiben-"Handling" bei der Herstellung von Halbleiterbauelementen erheblich.

Der Graben 7 wird in Schritt b) des Verfahrens zur Herstellung des Leistungsbauelements in die Scheibe 1 geätzt. Zum Ätzen des Grabens 7 in die Scheibe 1 wird eine Maske auf der Oberfläche des Chips aufgebracht. Die Maske ist so strukturiert, dass sie diejenigen Abschnitte des Chips abdeckt, die unverändert bleiben sollen, und so die Position der Gräben auf der Oberfläche des Chips definiert.

Der Graben hat vorzugsweise eine leicht abgeschrägte Form im Querschnitt, d. h. er stellt im Querschnitt ein Trapez dar, bei dem die kürzere der beiden parallelen Seiten unten auf der Substratseite liegt und die längere der beiden parallelen Seiten oben liegt und offen ist. Die kürzere parallele Seite und die beiden Schenkel des Trapezes definieren die frei liegende Oberfläche des Grabens 7, die im weiteren Verfahren in Schritt c) bearbeitet wird.

In Schritt c) des erfindungsgemäßen Verfahrens zur Herstellung eines Leistungsbauelements wird die frei liegende Oberfläche des Grabens 7 dotiert, so dass sich eine Schicht 6 vom zweiten Leitungstyp auf der Oberfläche des Grabens 7 bildet, d. h. in dem in Fig. 1 gezeigten Beispiel eines Leistungshalbleiters eine p-dotierte Schicht 6.

Neben der Oberfläche im Graben 7 wird in Schritt c) auch ein Anschlussbereich 9 am Rand der ersten Seite 3 der Oberfläche 2 der Scheibe 1 dotiert, wobei sowohl die Schicht 6 als auch der Anschlussbereich 9 vom zweiten Leitungstyp sind. Der Anschlussbereich 9 enthält den für die Rückwärtssperrfähigkeit erforderlichen Randabschluss des Bauelements. Dieser Randabschluss kann in Form von Feldringen, Feldplatten oder einer "variation of lateral doping"-Struktur sowie in weiteren üblichen Varianten erzeugt werden. Bei dem in Fig. 1 gezeigten Beispiel wird eine "variation of lateral doping"-Struktur als Randabschluss dargestellt. Die Wanne 10 stellt den Randabschluss für die kathodenseitige (emitterseitige) Basiszone des Leistungshalbleiters dar, der für die Vorwärtssperrfähigkeit des Bauelements erforderlich ist. Der Zentralbereich der Bauelements, der die kathodenseitige (emitterseitige) Emitterstruktur des Thyristors bzw. IGBT enthält, ist in Fig. 1 der Übersichtlichkeit halber nicht dargestellt.

Damit ein elektrischer Kontakt zwischen dem Substrat 5 und dem Anschlussbereich 9 durch die durch Dotieren der frei liegenden Oberfläche des Grabens 7 erzeugte Schicht 6 hergestellt werden kann, wird in Schritt b) des Verfahrens die Tiefe des Grabens 7 entsprechend gewählt. Die Tiefe des Grabens 7 hängt u. a. davon ab, ob eine bereits dotierte Schicht 8 in der Scheibe 1 vorgesehen ist oder nicht. Ist keine Schicht 8 in der Scheibe 1 vorgesehen, so wird die Tiefe des Grabens 7 vorzugsweise so gewählt, dass das Substrat 5 unter der Scheibe 1 freigelegt wird. Ist dagegen die Scheibe 1 mit einer bereits dotierten Schicht 8 versehen, so wird die Tiefe des Grabens 7 vorzugsweise so gewählt, dass eine Schicht der Scheibe 1 stehen bleibt, die eine vorgegebene Dicke hat. Die Dicke der Restschicht wird dabei vorzugsweise so festgelegt, dass der Boden des Grabens 7 in die Schicht 8 hineinreicht. Vorzugsweise können die Schichten 6 und 8 auch simultan diffundiert werden, indem vorher implantierte (Akzeptor-) Atome gemeinsam eindiffundiert werden. Die Implantation für die Schicht 8 hat hierbei vor dem Wafer-bonding und die Implantation für die Schicht 6 hat nach dem Wafer-bonding und der Grabenätzung zu erfolgen.

Durch das erfindungsgemäße Verfahren zur Herstellung eines Leistungshalbleiterbauelements wird somit eine Verbindung zwischen einer auf der Rückseite des Bauelements liegenden Elektrode und der Vorderseite des Bauelements geschaffen. Insbesondere wird durch die Überlappung der Dotierung am Boden des Grabens 7 mit der Dotierung des in der Fig. 1 dargestellten p⁺-Substrats 5 und die Überlappung mit der leitenden Schicht 6 die leitende Verbindung zwischen dem kathodenseitig (emitterseitig) rückwärtssperrenden Randabschluss und dem anodenseitigen (kollektorseitigen) p-Emitter hergestellt.

Vorzugsweise wird bei der Dotierung in Schritt c) des erfindungsgemäßen Verfahrens Bor als Dotierstoff verwendet.

Die Bordotierung zur Gewährleistung der leitenden Verbindung zwischen dem anodenseitigen (kollektorseitigen) p-Emitter und dem kathodenseitig (emitterseitig) realisierten rückwärtssperrenden Randabschluss kann z. B. durch eine maskierte Borimplantation mit einem nachfolgenden Eintreibschritt realisiert werden. Hierfür wird vorzugsweise eine Implantationsdosis zwischen 10¹⁴ und 10¹⁶ Boratomen pro cm² gewählt. Dadurch wird sichergestellt, dass es zu keinem Durchstoßen der Raumladungszone an die Oberfläche des Grabens kommt. Um die Oberflächeneinflüsse zu vermeiden, wird die Eindringtiefe der Boratome, also die Dicke der Schicht 6 vorzugsweise auf mindestens 3 µm festgelegt.

In einer alternativen Ausführungsform des Verfahrens erfolgt die Bor-Dotierung durch Diffusion, z. B. mittels Diboran-Diffusion. Vor der Bor-Diffusion wird dazu eine SiO₂-Schicht auf dem Chip aufgebracht, die die nicht zu diffundierenden Abschnitte des Chips abdeckt. Die SiO₂-Schicht wird so strukturiert, dass sie als Maske die Abschnitte auf der Chip-Oberfläche freigibt, die Bor-diffundiert werden sollen.

Nach Herstellung eines Wafers mit Leistungshalbleiterbauelementen mit dem erfindungsgemäßen Verfahren können einzelne Bauelemente voneinander entlang der Gräben getrennt werden. Diese Trennung der einzelnen Elemente erfolgt beispielsweise durch Sägen. Die Breite der Gräben wird vorzugsweise so gewählt, dass die Trennung der einzelnen Chips problemlos möglich ist, ohne das Randsystem der einzelnen Chips mit der ersten Schicht 6 und dem Anschlussbereich 9 zu beschädigen.

## Patentansprüche

1. Verfahren zum Herstellen mehrerer beidseitig sperrender, vertikaler Leistungsbauelemente auf einem Wafer, das umfasst: Erzeugen von Halbleiterstrukturen auf einer ersten Seite (3) der Oberfläche (2) einer Scheibe (1), wobei die Scheibe von einem ersten Leitungstyp ist und die Halbleiterstrukturen mindestens eine Wanne (10) von einem zweiten Leitungstyp an der Oberfläche (2) der Scheibe (1) umfassen,
**gekennzeichnet durch** die Schritte:
a) Verbinden der Scheibe (1) auf einer von der ersten Seite (3) der Oberfläche (2) abgekehrten zweiten Seite (4) der Scheibe (1) mit einem Substrat (5) von einem zweiten Leitungstyp zu einem Wafer;
b) Erzeugen von jeweils einem Graben (7) in der Scheibe (1) an dem Rand eines Leistungsbauelements auf dem Wafer;
c) Erzeugen eines Anschlussbereichs (9) von dem zweiten Leitungstyp auf der ersten Seite (3) der Scheibe (1), der einen Randabschluss für die Rückwärtssperrfähigkeit des Bauelements enthält, und einer ersten Schicht (6) von dem zweiten Leitungstyp auf der frei liegenden Oberfläche des Grabens (7), so dass ein elektrischer Kontakt zwischen dem Substrat (5) und dem Anschlussbereich (9) hergestellt wird.

2. Verfahren nach Anspruch 1,
**dadurch gekennzeichnet, dass**
eine zweite Schicht (8) von dem zweiten Leitungstyp auf der zweiten Seite (4) der Oberfläche (2) der Scheibe (1) erzeugt wird und die Scheibe (1) mit dem Substrat (5) über die zweite Schicht (8) verbunden wird.

3. Verfahren nach Anspruch 1 oder 2,
**dadurch gekennzeichnet, dass**
die Scheibe (1) und das Substrat (5) durch Wafer-Bonding miteinander zu einem Wafer verbunden werden.

4. Verfahren nach einem der Ansprüche 1 bis 3,
**dadurch gekennzeichnet, dass**
die erste und/oder zweite Schicht (6, 8) und/oder ein Anschlussbereich (9) durch Diffusion von Bor hergestellt wird.

5. Verfahren nach einem der Ansprüche 1 bis 3,
**dadurch gekennzeichnet, dass**
die erste und/oder zweite Schicht (6, 8) und/oder ein Anschlussbereich (9) durch Implantation von Bor und einen anschließenden Temperschritt hergestellt wird.

6. Verfahren nach Anspruch 5,
**dadurch gekennzeichnet, dass**
die Implantationsdosis zwischen 10¹⁴/cm² und 10¹⁶/cm² liegt.

7. Verfahren nach einem der Ansprüche 4 bis 6,
**dadurch gekennzeichnet, dass**
die erste Schicht (6) eine Dicke von mindestens etwa 3 µm erhält.

8. Verfahren nach einem der vorangehenden Ansprüche,
**dadurch gekennzeichnet, dass**
der Anschlussbereich (9) so erzeugt wird, dass seine Dotierung vom Rand aus abnimmt.

9. Verfahren nach Anspruch 8,
**dadurch gekennzeichnet, dass**
der Anschlussbereich (9) mit Feldringstrukturen versehen ist.

10. Verfahren nach Anspruch 8,
**dadurch gekennzeichnet, dass**
der Anschlussbereich (9) eine in einer Richtung parallel zur ersten Seite (3) der Oberfläche (2) der Scheibe (1) graduell abnehmende Dotierung aufweist.

11. Verfahren nach einem der vorangehenden Ansprüche,
**dadurch gekennzeichnet, dass**
der Halbleiter entlang des Grabens (7) in einzelne Chips getrennt wird.

12. Verfahren nach Anspruch 11,
**dadurch gekennzeichnet, dass**
das Trennen durch Sägen durch die Grabenmitte erfolgt.

## Claims

1. Method for fabricating a plurality of bilaterally blocking, vertical power components on a wafer, comprising:
producing semiconductor structures on a first side (3) of the surface (2) of a slice (1), the slice being of a first conduction type and the semiconductor structures comprising at least one well (10) of a second conduction type at the surface (2) of the slice (1),
**characterized by** the steps of:
a) connecting the slice (1) on a second side (4) of the slice (1), said second side being remote from the first side (3) of the surface (2), to a substrate (5) of a second conduction type to form a wafer;
b) producing a respective trench (7) in the slice (1) at the edge of a power component on the wafer;
c) producing a connection region (9) of the second conduction type on the first side (3) of the slice (1), which connection region contains an edge termination for the reverse blocking capability of the component, and a first layer (6) of the second conduction type on the uncovered surface of the trench (7), so that an electrical contact is produced between the substrate (5) and the connection region (9).

2. Method according to Claim 1,
**characterized in that**
a second layer (8) of the second conduction type is produced on the second side (4) of the surface (2) of the slice (1) and the slice (1) is connected to the substrate (5) via the second layer (8).

3. Method according to Claim 1 or 2,
**characterized in that**
the slice (1) and the substrate (5) are connected to one another by wafer bonding to form a wafer.

4. Method according to one of Claims 1 to 3,
**characterized in that**
the first and/or second layer (6, 8) and/or a connection region (9) is fabricated by diffusion of boron.

5. Method according to one of Claims 1 to 3,
**characterized in that**
the first and/or second layer (6, 8) and/or a connection region (9) is fabricated by implantation of boron and a subsequent heated treatment step.

6. Method according to Claim 5,
**characterized in that**
the implantation dose lies between 10¹⁹/cm² and 10¹⁶/cm².

7. Method according to one of Claims 4 to 6,
**characterized in that**
the first layer (6) acquires a thickness of at least approximately 3 µm.

8. Method according to one of the preceding claims,
**characterized in that**
the connection region (9) is produced in such a way that its doping decreases from the edge.

9. Method according to Claim 8,
**characterized in that**
the connection region (9) is provided with field ring structures.

10. Method according to Claim 8,
**characterized in that**
the connection region (9) has a doping that decreases gradually in a direction parallel to the first side (3) of the surface (2) of the slice (1).

11. Method according to one of the preceding claims,
**characterized in that**
the semiconductor is separated into individual chips along the trench (7).

12. Method according to Claim 11,
**characterized in that**
the separation is effected by sawing through the trench centre.

## Revendications

1. Procédé de fabrication sur une plaquette de plusieurs composants de puissance, verticaux, bloquants dans les deux sens, comprenant : la création de structures de semi-conducteurs sur un premier côté (3) de la surface (2) d'une pastille (1), la pastille étant d'un premier type de conduction et les structures de semi-conducteurs comprenant au moins une cuve (10) d'un deuxième type de conduction sur la surface (2) de la pastille (1),
**caractérisé par**
les étapes de :
(a) raccordement de la pastille (1) sur un deuxième côté (4) de la pastille (1) détourné du premier côté (3) de la surface (2) avec un substrat (5) d'un deuxième type de conduction à une plaquette ;
(b) création respectivement d'une fosse (7) dans la pastille (1) sur le bord d'un composant de puissance sur la plaquette ;
(c) création d'une zone de raccordement (9) du deuxième type de conduction sur le premier côté (3) de la pastille (1), qui contient une bordure pour la capacité de blocage dans le sens inverse du composant, et d'une première couche (6) du deuxième type de conduction sur la surface libre de la fosse (7), de sorte qu'on établit un contact électrique entre le substrat (5) et la zone de raccordement (9).

2. Procédé selon la revendication 1,
**caractérisé en ce qu'**
une deuxième couche (8) du deuxième type de conduction est créée sur le deuxième côté (4) de la surface (2) de la pastille (1), et la pastille (1) est reliée au substrat (5) à l'aide de la deuxième couche (8).

3. Procédé selon la revendication 1 ou 2,
**caractérisé en ce que**
la pastille (1) et le substrat (5) sont reliés entre eux à une plaquette par connexion sur plaquette.

4. Procédé selon l'une quelconque des revendications 1 à 3,
**caractérisé en ce que**
la première et/ou la deuxième couche(s) (6, 8) et/ou une zone de raccordement (9) est créée par diffusion de bore.

5. Procédé selon l'une quelconque des revendications 1 à 3,
**caractérisé en ce que**
la première et/ou la deuxième couche(s) (6, 8) et/ou une zone de raccordement (9) est créée par implantation de bore et d'une étape de trempe successive.

6. Procédé selon la revendication 5,
**caractérisé en ce que**
la dose d'implantation est située entre 10¹⁴/cm² et 10¹⁶/cm².

7. Procédé selon l'une quelconque des revendications 4 à 6,
**caractérisé en ce que**
la première couche (6) a une épaisseur d'au moins 3 µm environ.

8. Procédé selon l'une quelconque des revendications précédentes,
**caractérisé en ce que**
la zone de raccordement (9) est créée de telle sorte que son dopage diminue à partir du bord.

9. Procédé selon la revendication 8,
**caractérisé en ce que**
la zone de raccordement (9) est munie de structures en anneau de champ.

10. Procédé selon la revendication 8,
**caractérisé en ce que**
la zone de raccordement (9) présente un dopage diminuant graduellement dans une direction parallèle au premier côté (3) de la surface (2) de la pastille (1).

11. Procédé selon l'une quelconque des revendications précédentes,
**caractérisé en ce que**
le semi-conducteur est séparé le long de la fosse (7) en différentes puces.

12. Procédé selon la revendication 11,
**caractérisé en ce que**
la séparation est réalisée par sciage au milieu de la fosse.
